Europäisches Patentamt

(19) European Patent Office

Office européen des brevets

(11) Publication number: **0 221 895**
**B1**

(12) **EUROPEAN PATENT SPECIFICATION**

(45) Date of publication of patent specification: **11.10.89**

(21) Application number: **85902834.2**

(22) Date of filing: **17.05.85**

(86) International application number:
**PCT/US85/00925**

(87) International publication number:
**WO 86/06708 20.11.86 Gazette 86/25**

(51) Int. Cl.⁴: **B 67 B 5/00, B 67 B 7/48**

(54) Container for corrosive liquids.

(43) Date of publication of application:
**20.05.87 Bulletin 87/21**

(45) Publication of the grant of the patent:
**11.10.89 Bulletin 89/41**

(84) Designated Contracting States:
**AT BE CH DE FR GB IT LI LU NL SE**

(56) References cited:
US-A-1 189 465
US-A-2 091 737
US-A-2 099 370
US-A-2 114 583
US-A-2 200 600
US-A-2 608 989
US-A-3 438 656
US-A-3 463 339
US-A-4 134 514
US-A-4 298 037

(73) Proprietor: **J.C. SCHUMACHER COMPANY**
**580 Airport Road**
**Oceanside California 92054 (US)**

(72) Inventor: **GRAF, Hans-Juergen**
**1847 Campesino Place**
**Oceanside, CA 92054 (US)**

(74) Representative: **Abrams, Michael John et al**
**Haseltine Lake & Co. 28, Southampton Buildings**
**Chancery Lane**
**London WC2A 1AT (GB)**

Courier Press, Leamington Spa, England.

**Description**

This invention relates to a container for shipping, storing and using toxic corrosive and ultra pure liquid chemicals for use in manufacturing semiconductors, and to a method of handling such chemicals.

It is well established that the successful manufacturing of semiconductor devices is dependent upon the use of high purity raw materials. Reliability improvements and improvements in basic physical parameters such as junction leakage, flat band voltage shift, minority carrier lifetime, etc. illustrate the necessity of maintaining a high degree of purity in raw materials. The yield of usable components is also dependent upon raw material purity. Manufacturing of semiconductor devices is a high volume, low unit cost process. Competitive pressures result in drastic price erosion for a given semiconductor device until the high volume, low cost equilibrium state is achieved. Since the quality and device yield are highly dependent upon the purity of raw materials, the equilibrium, or profitable state requires constant raw material purity.

The substances used in manufacturing semiconductor and optical fiber devices include phosphorus oxychloride, phosphorus trichloride, trichloroethane, tetraethyl orthosilicate, silicon tetrabromide, phosphorus tribromide, arsenic trichloride, etc. These chemicals are generally in liquid form and are hazardous to varying degrees. Therefore, they require a minimum or zero exposure to workers handling them.

In the United States, such corrosive materials, class B poisons and the like are subject to regulation by the Department of Transportation and other governmental agencies. Regulations, health and safety factors must be considered in shipping, storing and using these liquid materials.

In the semiconductor manufacturing industry, these chemicals are ordinarily removed from a container by passing an inert gas through the liquids. The gas becomes saturated with the vapors of the chemical by bubbling through the liquid. The gas exits the container, carrying the chemical vapors to a diffusion furnace or to a thin film reactor.

The standard container used for storing, shipping and using liquid chemicals in semiconductor and optical fiber fabrication is a bubbler produced by the assignee of the present invention and described in U.S. Patents Nos. 4,134,514 and 4,298,037. The bubbler includes a generally cylindrical container that is partially filled with the liquid chemical and hermetically sealed to provide complete isolation of the chemical from the environment. The bubbler includes an inlet tube and an outlet tube. Each of the inlet and outlet tubes includes a quartz break seal and an outer seal extending across the tube to prevent access to the container.

The bubbler is used by first breaking or removing the external or outer seals and connecting the inlet tube to a carrier gas supply and the outlet tube to a system to receive the chemical substance contained in the bubbler. Inlet and outlet shutoff valves are attached to the tubes, and the spaces between the inlet and outlet tubes between the respective valves and the inner breakable seals are then flushed with dry, clean inert gas to remove atmospheric moisture that may have collected there. The internal seals may then be broken.

Although the bubbler described above is satisfactory for maintaining the integrity of ultra-high purity chemicals and protecting the environment from contamination, the bubbler is costly to manufacture, and the quartz break seals are a considerable factor in the costs. Since at least the inner seal must be broken to remove the chemical from the bubbler container, the bubbler requires costly refurbishment for subsequent reuse.

Accordingly, there is a need in the art for a relatively simple and inexpensive bubbler closure to provide total containment of a corrosive chemical substance during storing, shipping and use. There is also a need in the art for a bubbler closure which eliminates the necessity of costly refurbishment before reuse, simpler to manufacture and which simplifies the filling and sealing of the ultra-high purity chemical in the bubbler and facilitates safe handling of the bubbler and enclosure chemical.

According to one aspect of the present invention there is provided a container for shipping, storing and using ultra-pure corrosive and poisonous liquid reagents for use in the manufacture of semiconductors, which reagents must be protected from exposure to air and from transmission of gas or vapour through containment walls, the container comprising:

a vessel having containment walls formed of gas and vapour impervious material which is chemically inert to the liquid reagent to be contained therein, said vessel comprising an inlet in an upper region of said vessel, a conduit in fluid communication with said inlet and extending therefrom to a lower region of the interior of the vessel for permitting gas to be introduced below the surface of the liquid reagent to be contained in the vessel, an outlet in the upper region of the vessel via which liquid vapour bearing can be removed from the vessel, and a seal arranged at the inlet to form a barrier to the passage of gas into the vessel, characterised in that the seal comprises:

(i) a first layer of material which is chemically inert to the liquid reagent to be contained in said vessel, said first layer being a layer of such thickness that is capable of being penetrated by a sharp hollow needle,

(ii) a second layer of resilient material so arranged as, in use, to be readily capable of being penetrated by a sharp hollow needle and gripping said needle in a fluid tight seal therewith, the first layer being impervious to gas for preventing entry of gas into the inlet through the seal, there being means securing the seal at the inlet in fluid impervious sealing relation thereto.

Preferably the seal comprises a third layer of material which is chemically inert to the liquid reagent to be contained in the vessel, the third layer being a layer of such a thickness it is capable of being penetrated by a sharp hollow needle.

The following prior art is in relation to seals for various vessels. None of the documents are connected with the sealing of semiconductor reagent bubbler containers and are made of record for interest only.

US—A—1,189,465 describes a container for hypodermic solutions with a closure having a sealing disk of soft rubber which will permit a hypodermic needle to be inserted into the container but which will immediately close up when the needle is withdrawn.

US—A—2,099,370 describes a cap for a phial having two thin layers with a layer of compressible material therebetween. The layer of compressible material has an orifice to permit a needle to pass therethrough in a fluid tight manner.

US 2—A—114583 describes a cap for a drink bottle having a thin disc and a resilient washer which can be penetrated by a nozzle.

The container can further include means securing the seal over the inlet in fluid tight sealing relation thereto; a valve mounted on said conduit in fluid tight relation therewith, said valve comprising a body having a valving passage therethrough which encloses the seal and a further passage for providing communication between an external conduit and the valving passage; a valving member mounted for reciprocal movement in the valving passage for sealing said valving passage; a hollow needle having a sharp point formed on a free end thereof received in the valving passage; and supported for reciprocal movement in the valving passage; the valving body, valving member and needle being composed of material which is chemically inert to the liquid to be contained in the container and so arranged that upon movement of the valving member in the valving passage in a predetermined direction the valving member forces the sharp point of the needle through the layers of the seal thereby opening a fluid path through the layers from the valving passage to the vessel.

According to a further aspect of the invention there is provided a method of transferring ultra-pure corrosive and poisonous liquid reagents which must be protected from exposure to air and from transmission of gas or vapour through containment walls to or from a vessel according to said one aspect of the invention characterised by:

mounting a valve onto at least one of the vessel conduit and outlet in fluid tight relation therewith, said valve comprising a body having a valving passage therethrough which receives the conduit, a further passage (54) for communicating between an outside conduit and the valving passage, and a hollow needle having a sharp point formed on a free end thereof in the valve, the valve being composed of material which is chemically inert to the reagent; and

moving the needle in the valve in a predetermined direction thereby forcing the sharp point of the needle through a seal arranged in the conduit thereby opening a fluid path through the seal from the valving passage to the vessel, the seal comprising at least a first layer sealed in gas-tight relation to and closing the inlet, the first layer being composed of material which is chemically inert to the semiconductor reagent and being of such a thickness as to be capable of being penetrated by tha sharp hollow needle, and a second layer composed of resilient material so composed and configured as to be readily capable of being penetrated by the sharp hollow needle and gripping said needle in fluid tight seal therewith whereby reagent can be removed from or introduced into the vessel via the fluid path so formed.

The invention is particularly applicable in the manufacture of semiconductors wherein a gas is bubbled through a liquid reagent.

In a still further aspect of the invention, there is provided a valve for use with a container according to said one aspect of the invention, the valve comprising a body having a valving passage therethrough and a passage for communicating to an outside conduit in communication with the valving passage, a valving member received in the valving passage and sealing said passage, the valving member being mounted for reciprocal movement in the valving passage, a hollow needle having a sharp point formed on a free end thereof received in the valving passage, means supporting the needle in the valving passage for reciprocal movement in the valving passage, the valving body, valving member, support means and needle being so constructed, mounted and disposed that upon movement of the valving member in the valving passage in a predetermined direction the valving member moves the needle in the direction of the sharp point thereof, the valve body, needle and support means being composed of material which is chemically inert.

An embodiment of the present invention provides a container for chemicals which must be protected from exposure to air and from inflow of gas or vapor through containment walls. The container is a vessel composed of gas and vapour impervious material, typically quartz, nickel, or other material or combinations of materials which are chemically inert to the chemical to be contained therein. The vessel comprises at least one conduit extending therefrom, that conduit being in communication with the interior. Typically, vessels of the type under consideration have two or three conduits, typically two. Sometimes a conduit is used for filling and is not later used. The vessel may also include wells and other structure for measuring temperature, heating the chemical, etc., all of which are composed of chemically inert material, with respect to the contained chemical. The container also includes sealing means secured to the end of the conduit and closing off the end thereof and sealing the end against entry of air and vapour. The sealing means comprises a multiple layer sandwich of sealing materials which form a barrier to the introduction of air and vapor into the vessel. This sandwich of materials includes a first layer which is composed of a material which is chemically inert to the contained chemical. This first layer is composed and constructed to be readily capable of being penetrated by a sharp hollow needle. The first layer or bottom layer, in that it is in contact with the open end of the conduit and seals that end, can be made of a noble metal, tantalum or a fluorocarbon polymer, such as polytetrafluoroethylene, sold under the tradename "Teflon". The term polytetrafluoroethylene will be used here to generally describe this class of polymers, although there are variations in such fluorocarbon polymers. The second layer of the sealing means is composed of a resilient material, such as silicone rubber, butyl rubber, Viton synthetic rubber, Hycar synthetic rubber, Neoprene synthetic rubber, Kalrez synthetic polymer, all of which are generally referred to here as synthetic rubber polymers. These materials are capable of being penetrated by a sharp needle and when penetrated they grip the outer circumference of the needle in a fluid tight seal. Means are provided for securely fastening the sealing means on the end of the conduit in fluid tight sealing relation thereto. Typically, a crimp, designed with a circular center hole and engaging in a groove or collar in the outer circumference of the conduit is provided as the fastening means for the sealing means, but any convenience fastening means may be used. Suitable adhesives, or potting compounds, for example, could be used.

A third layer also composed of chemically inert material is provided on the upper or outer side of the sandwich sealing means. This third layer may be of any of the inert materials mentioned and could be formed of polytetrafluoroethylene or an inert metal such as tantalum. The first and third layers may be substantially identical, except for their relationship one to another and to the vessel and the conduit, or they may be different. For example, one may use a polytetrafluoroethylene material for the first layer and a metal for the third, or visa versa.

In a preferred embodiment of the invention, a fourth layer is provided between the second and third layers. The fourth layer can be substantially identical to the second layer and, whether or not made of the same material, also grips the needle and forms a sealing relationship therewith. In this embodiment, the securing means is a crimp fastener having portions which extend inwardly between the second and fourth layers of the sealing means and having a crimped portion which engages in a groove or collar in the circumference of the vessel conduit.

An embodiment of the method aspect of the invention involves the filling of a container of the type described above and the sealing of that container with the seal of the type described above. A further embodiment of the invention contemplates a container as described in combination with a valve mounted on the conduit in fluid tight relationship therewith. The valve comprises a body having a passage therethrough which encloses the sealing means and also a passage communicating to an outside conduit. These two passages communicate with one another to permit introduction of high purity gas or fluid into the container or removal of high purity gas or fluid from the container. The body of the valve forms a valving passage which receives a valving member which seals the passage at one end. The valving member is mounted for movement in the valving passage to open and close the valve. A hollow needle having a sharp end formed on one end thereof is also received in the valving passage. The valving body and valving member are so constructed, mounted with respect to each other and disposed that, upon movement of the valving member in the valving passage in a predetermined direction, the valving member forces the sharp point of the needle through the sealing means thereby opening a fluid path through the sealing means from the interior of the container to the valving passage. This enables introduction of fluid into or removal of fluid from the container. In one preferred embodiment of this combination, the needle is supported inside the valve passage by means which permit it to move reciprocally and seal against the walls of the valve passage.

In one view of the invention, a unique valve construction is provided. The valve comprises the body, having the passages described, the valving member and the needle, assembled and in combination with one another such that upon movement of the valving member in one direction, the needle is forced toward the pointed end thereof, thereby permitting the forcing of the needle, when the valve is in use, through a sealing means comparable to or the same as that previously described. New valve will, typically, include means for securing the valve on the end of a conduit, for securing conduits to the valve, etc., as is conventional in valve manufacture. One preferred form of this valve includes a disk secured to one end of the needle, the disk positioning the needle in the valve passage, sealing the valve passage, and maintaining the needle in position before and during and after use.

One form of the invention also contemplates a method of receiving a chemical of the type described in a container of the type described, fitting the valve to the container, moving the valving member and thereby opening the interior of the container to receive or to dispense fluid. It will be apparent from the foregoing discussion that there are many novel and highly advantageous facets of the invention. The invention, thus, contemplates a new valve, a new container, a new sealing means, a new combination of these, and methods for using the same.

Brief description of the drawings

Figure 1 is a cross-sectional view of a bubbler container for corrosive liquid chemicals showing an inlet valve and an outlet valve connected thereto;

Figure 2 is a cross-sectional view of the inlet and outlet valves showing the septum closure of the invention being retained between a stem extending from the bubbler container and a valve body; and

Figure 3 is a cross-sectional view illustrating the septa of Figure 1 being penetrated by a needle in the valve body.

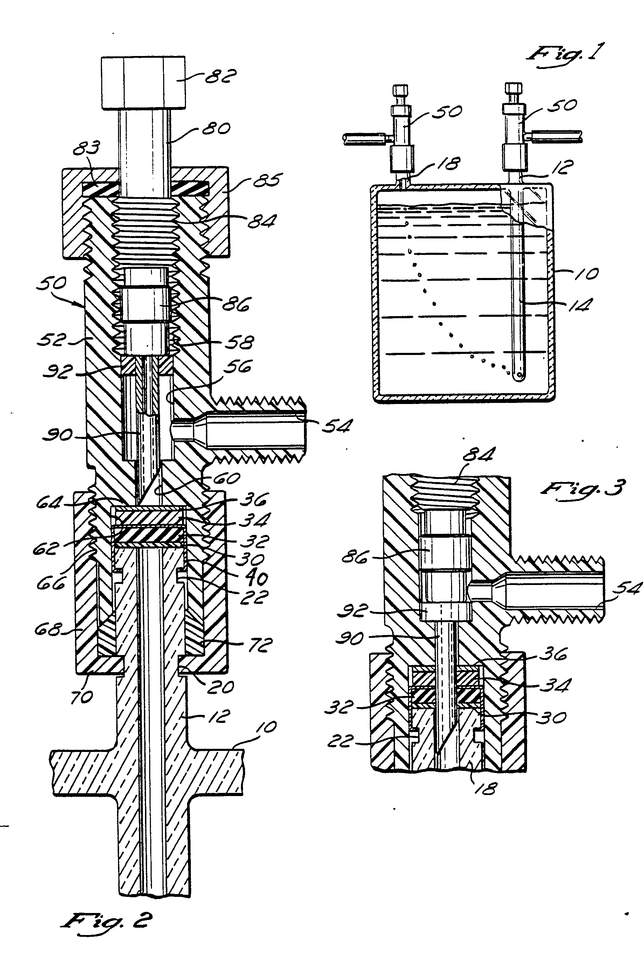

Reference is made first to Figure 1 which depicts a complete container of an embodiment of this invention. The container includes a vessel 10 which is made of a material which is inert to the chemical to be contained therein, which is impervious to gas and vapor, and which is sufficiently strong to permit reasonable handling and shipping. Such containers are typically made of quartz, but may be made of other materials. For example, in some utilizations the vessel may be made of nickel or tantalum. The vessel could theoretically, also be made of a noble metal but this might be unduly expensive. In some applications, the vessel could be made of a sandwich of multiple materials. For example, if suitable quality control and manufacturing assurance can be maintained, it would be possible to provide a container of metal coated polymer, for example, nickel coated polytetrafluoroethylene. Likewise, if suitable quality can be obtained, it would be possible to make it a container of a metal which need not be totally resistant to the chemical coated internally with polytetrafluoroethylene. Both of these approaches are attractive in concept but face the serious challenge that it is very difficult if not impracticable to maintain quality assurance standards such that a risk of a leak or pin-hole or thin area in the polytetrafluoroethylene is totally avoided. The vessel includes at least one conduit extending therefrom and in communication with the interior thereof. One such conduit is shown at 12 which includes an extension 14 going near to the bottom of the vessel with an opening at the bottom of the extension conduit 14. This is used in a bubbler configuration for bubbling ultra-high purity gas through the chemical contained in the vessel and removing the vapor laden gas from another conduit 18 which also communicates with the interior of the vessel. Vessels of this type are described in the aforementioned United States Patent 4,134,314, it being understood that Figure 1 is somewhat simplified and schematically illustrates the vessel construction.

Taking the conduit 12 as typical of conduits which may be formed on the vessel as part of the container, such a conduit, preferably, is of a thick wall construction and has formed in the outer periphery thereof two annular grooves 20 and 22 or collars or one of each. The groove 20 is used to connect a valve and the groove 22 is used to connect a sealing means, all as will be described in greater detail hereinafter.

The container also includes sealing means which is a sandwich arrangement comprising layers 30, 32, 34, and 36, all held in place by fastening means 40. Not all of these layers are always necessarily required, but the preferred embodiment does include the layers described.

The layer 30 must be of a material which is chemically inert to the contained chemical. This may be made of a noble metal, a chemically resistant metal or a chemically resistant polymer. In addition to the noble metals, which form excellent seals but are very expensive, one may use tantalum which has a very high resistance to chemical attack from most chemical reagents. One may also use certain polymeric materials, generally referred to here as polytetrafluoroethylene or fluorocarbon polymers. A polymer of this type is sold under the trademark TEFLON by Du Pont Chemical Company. Comparable or suitable fluorocarbon materials may be obtained from a number of sources. The fluorocarbon materials have the distinct advantage that they form excellent seals under pressure, in that they cold flow to conform to the configuration of the opening which they must seal. The metals also cold flow to some extent but often greater force is required to form a tight seal. The noble metals and tantalum have the advantage that they are, for all practical purposes, totally impervious to gas, whereas, the fluorocarbon polymers are not totally gas impervious. For present purposes, however, where the area is small, and the thickness may be substantial and where a sandwich construction is used, fluorocarbon polymers may be considered as substantially gas and vapor impervious within the context and within the limitations of the present invention.

A second layer 32 is also provided. This layer is of a resilient sealing material, generally referred to here simply as synthetic rubber polymers. Silicon rubber, butyl rubber, Viton, Hycar, Neoprene, and Kalrez, among others, may suitably be applied in this invention. These materials are characterized in that they can be penetrated and when penetrated, by a holow needle for example, they seal around the outer circumference of the needle in a tight substantially gas impervious seal.

In the preferred embodiment, at least one additional layer, and preferably two, are provided. The third layer, which is identified here as number 36 in Figure 2, is highly preferred. This layer may be identical to the layer 30 and, normally, would be so. It may differ, in that it may be made of metal while the layer 30 is made of polymer, or, visa versa, the layer 30 may be made of metal while the layer 36 is made of polytetrafluoroethylene, for example. The purpose of the layer 36 is to provide a chemically inert outer or upper surface. As will be seen, if, in the combination, the valve does not totally seal around the needle, this surface may be exposed to the chemical contained in the vessel. In the most preferred embodiment, a fourth layer 34 is provided between the second and third layers 32 and 36. The fourth layer, typically, is the same or substantially identical to the layer 32, or at least has the same sealing, resilient characteristics, although it may be made of a different material.

The entire sealing means as just described is securely fastened to the end of the conduit and closes off the end of the conduit by a fastening means shown at 40. The fastening means, in the preferred embodiment, is a crimp fastener which has a portion extending between layers 2 and 3 of the sealing means and has another portion which is crimped and grips in the groove 22 holding the sealing means tightly in sealing relationship with the end of the conduit. The crimp fastener, typically, has an aperture through which the needle can extend when it penetrates the seal, as will be described hereinafter. By appropriate selection of materials, and thicknesses, it is also possible to use a crimping cap which covers the entire area over the second layer, thus providing a further gas and vapor barrier during handling. For example, a crimp made of nickel with a thinned center area on the top could be used as a gas barrier during transit, and as part of the sealing means.

The process of an embodiment of this invention includes filling the vessel with the chemical to be contained therein, in the absence or substantially absence of air or vapor which would react therewith or tend to contribute impurities thereto, and then sealing the vessel to provide the container as described with the sealing means a part thereof.

A valve, generally shown at 50, is assembled over the end of the conduit in a fluid tight sealing relationship. The valve 50 includes a valve body 52 which has formed therein a conduit 54 to permit the introduction into or removal of fluid from a valving passage 56 which extends through the valve body. The passage 56 also has a threaded portion 58 and a reduced portion 60 which forms a shoulder with an enlarged portion 62. The enlarged portion 62 extends over the sealing means and is secured in place as will be described. The shoulder 64, between the portions 60 and 62 of the passage seals against the third layer of the sealing means, thus providing a gas-tight, chemically inert containment for the chemical to be contained in the vessel. The valve body has an exterior threaded portion 66 which threadably engages with a retaining nut 68, which has a portion 70 which extends into the groove 20. A gasket or ferrule 72 is provided to assure a totally gas-tight seal between the valve and the conduit, enclosing the sealing means within the valve passage. The valve also includes a valving member 80, in the preferred configuration, is generally elongate having an upper end 82 which may be in the form of a handle, hexagonal or square head, or in any other configuration to permit gripping said turning thereof. Also formed on the valving member are threads 84 which engage in a threaded portion 58 of the valve passage in the valve body. A sealing gasket 83, or an "O" ring seal, is expanded by the cap 85 against the shaft 80 forming a gas tight seal. An enlarged portion 86 also seals against the walls of the valve passage when the valve is in use. By turning the valving member 80, it will move inwardly or outwardly, reciprocally, in the valving passage. A very important and significant feature of this invention is the placement of a needle in the valving passage. The needle 90 has a sharp end at one end, a free end, shown adjacent the sealing means. In the preferred embodiment, support means 92 is also provided. This support means centers the needle, holds it in position, and seals against the walls of the valving passage.

The operation of the above described can now be described.

Referring first to Figure 2, the combination is formed, according to the method of this invention, by affixing the valve on the conduit in a gas sealed relationship, as described. The valving member is then turned or otherwise actuated, and moved in a predetermined direction, downwardly as shown in Figure 2. As it moves down, the needle 90 penetrates the sealing means. The full down position of the valve as shown in Figure 3, which is a partial cross-section of that portion of the valve necessary to show the position of the needle. As is seen in Figure 3, the needle penetrates through the sealing means and opens the conduit passage to the valving passage, thus permitting introduction into or removal of fluid to or from the vessel. Typically, the valving member would be withdrawn a small distance to permit fluid to flow from the vessel, through the needle, into the valve passage, and then through the communicating passage 54.

Thus, in one contemplation of the invention, the user of the invention receives a container, as described, affixes a valve, as described thereto, and operates the valve as described, thereby obtaining access to the chemical contained therein, or fills the vessel, as may be the purpose of the user.

As will be understood from the foregoing description, the septum is constructed as a sandwich, having a bottom layer of a totally inert material, such as a chemically compatible, nonreactive metal, for example, tantalum or a noble metal and/or a fluorocarbon polymer, such as Teflon. The top layer of the sandwich should be made of a pliable, vapor impermeable, chemically compatible compound, such as silicone rubber, butyl rubber, Viton, Hycar, Neoprene, Kalraz, etc., which exhibits good sealing characteristics. The bottom layer of the septum should be the only layer exposed to the contained chemical. The septum itself is tightly attached to the stem with a crimp, designed with a circular centerhold for unobstructed needle movement and optimum sealing characteristics.

An additional septum is placed on top of the crimp and septum arrangement, just described, to facilitate additional upward sealing. The septum is held firmly in place with a simple protective plastic cap during storage or transportion, or with the valve when the bubbler is in use. This secondary sealing septum is made of the same material as that described and is constructed in a similar sandwich-type construction, using a layer of a totally inert material, such as a noble metal or tantalum, or a fluorocarbon polymer, and a sealing impermeable compound, such as silicon rubber, all as described before. In this arrangement, the secondary septum is placed with its inert side up, outwardly from the chemical and its sealing side down toward the crimp. In this fashion, the chemical is allowed only to contact inert material and thus its ultra-purity is maintained.

In accordance with one embodiment of the invention, two valves are supplied for controlling the flow of carrier gas in or out of the bubbler. The valves are considered the inlet and outlet ports of the bubbler and are manufactured of a material which is totally compatible with the ultra-high purity nature of the chemical, such as a fluorocarbon polymer, Teflon, for example. The valves used as the inlet or outlet are so called "two-way" valves, which are equipped with a movable, internal hollow needle to allow the carrier gas to pass through the needle. The needle is preferably made of quartz, noble metal such as platinum, tantalum, or fluorocarbon polymercoated stainless steel. The top of the needle is attached to and oriented within the valve body with the help of a small needle support plate, typically made of quartz, noble metal, tantalum or fluorocarbon polymer, to facilitate proper directional guidance of the needle. The needle is made with a 90 degree cut across the top while the bottom tip has about a 22 degree bevel point for easy septum penetration, or a conical point with a side port opening to facilitate septum penetration without septum cord cutting and possible contamination.

The valve is designed to allow the hollow needle to rest on the upper septum before opening. For use, the valve stem is rotated downwardly, which forces the needle to penetrate both septa. Following penetration, the valve stem is rotated upwardly to the stop, thus leaving the needle and support plate in its bottom location and clearing the opening of the valve chamber to facilitate the entry and exit of gases or fluids. Leakage to and from the outside is prevented through the upper internal valve seal and the sealing of the septum arrangement. The integrity of the ultra-high purity chemical is warranted by allowing the chemical to contact only totally inert materials, e.g. quartz, noble metal, tantalum or fluorocarbon polymer.

It will be understood that the foregoing is the preferred embodiment of the invention and that variations therein may be made within the scope of the claims.

Industrial application

This invention finds industrial application in the manufacture of semiconductor devices and, more particularly, in providing, shipping and handling doping and other chemical reagents for the semiconductor industry.

Claims

1. A container for shipping, storing and using ultra-pure corrosive and poisonous liquid reagents for use in the manufacture of semiconductors, which reagents must be protected from exposure to air and from transmission of gas or vapour through containment walls, the container comprising:

a vessel (10) having containment walls formed of gas and vapour impervious material which is chemically inert to the liquid reagent to be contained therein, said vessel comprising an inlet (12) in an upper region of said vessel, a conduit (14) in fluid communication with said inlet and extending therefrom to a lower region of the interior of the vessel for permitting gas to be introduced below the surface of the liquid reagent to be contained in the vessel, an outlet (18) in the upper region of the vessel via which liquid vapour bearing gas can be removed from the vessel, and a seal arranged at the inlet to form a barrier to the passage of gas into the vessel, characterised in that the seal comprises:

(i) a first layer (30) of material which is chemically inert to the liquid reagent to be contained in said vessel, said first layer being a layer of such thickness that is capable of being penetrated by a sharp hollow needle, and

(ii) a second layer (32) of resilient material so arranged as, in use, to be readily capable of being penetrated by a sharp hollow needle and gripping said needle in a fluid tight seal therewith, the first layer being impervious to gas for preventing entry of gas into the inlet through the seal, there being means (40) securing the seal at the inlet in fluid impervious sealing relation thereto.

2. A container as claimed in Claim 1, wherein the seal comprises a third layer (36) of material which is chemically inert to the liquid reagent to be contained in the vessel, the third layer being a layer of such a thickness it is capable of being penetrated by a sharp hollow needle.

3. A container according to Claim 2, wherein at least one of the first (30) and third (36) layers is composed of a metal which is inert to the liquid reagent to be contained therein and impervious to gas.

4. A container according to Claim 2 or 3, wherein at least one of the first and third layers is composed of tetrafluoroethylene.

5. A container according to any preceding claim, wherein the second layer is composed of a resilient synthetic rubber polymer.

6. A container according to claim 2, 3 or 4 wherein:

the seal further comprises a fourth layer (34) of resilient sealing polymer between the second and third layers;

the inlet is defined by the end of the conduit (14) which extends into the vessel;

the conduit comprises an annular groove (22) formed in the outer circumference thereof; and

the securing means (40) comprises an annular crimp fastener which includes a first portion extending between the second and fourth layers of the sealing means, an intermediate sleeve portion around a portion of the seal and a portion of the conduit, and a crimp portion extending into the annular groove in the conduit.

7. A container as claimed in any preceding claim, comprising a valve (50) mounted on said conduit in fluid tight relation therewith, said valve comprising a body (52) having a valving passage (56) therethrough which encloses the seal and a further passage (54) for providing communication between an external conduit and the valving passage; a valving member (80) mounted for reciprocal movement in the valving passage for sealing said valving passage; a hollow needle (90) having a sharp point formed on a free end thereof received in the valving passage and supported for reciprocal movement in the valving passage; the valving body, valving member, and needle being composed of material which is chemically inert to the liquid to be contained in the container and so arranged that upon movement of the valving member in the valving passage in a predetermined direction the valving member forces the sharp point of the needle through the layers of the seal thereby opening a fluid path through the layers from the valving passage to the vessel.

8. A container according to Claim 2, wherein at least one of the first and third layers is a thin inert metal sheet.

9. A method of transferring ultra-pure corrosive and poisonous liquid reagents which must be protected from exposure to air and from transmission of gas or vapour through containment walls to or from a vessel (10) as claimed in any of claims 1 to 6 characterised by:

mounting a valve (50) onto at least one of the vessel conduit and outlet in fluid tight relation therewith, said valve comprising a body (52) having a valving passage (56) therethrough which receives the conduit, a further passage (54) for communicating between an outside conduit and the valving passage, and a hollow needle having a sharp point formed on a free end thereof in the valve, the valve being composed of material which is chemically inert to the reagent; and

moving the needle in the valve in a predetermined direction thereby forcing the sharp point of the needle through a seal arranged in the conduit thereby opening a fluid path through the seal from the valving passage to the vessel, whereby reagent can be removed from or introduced into the vessel via the fluid path so formed.

10. A method as claimed in Claim 9, when used in the manufacture of semiconductors to transfer reagent from the vessel, characterised by:

mounting said valve on an inlet (12) of the vessel;

introducing gas through the needle and the conduit into the vessel below the level of reagent contained in the vessel; and

collecting reagent vapour-bearing gas which issues from an outlet of the vessel.

11. A valve for use with the container as claimed in any one of claims 1 to 6 comprising a body (52) having a valving passage (56—60) therethrough and a passage (54) for communicating to an outside conduit in a communication with the valving passage, a valving member (80—88) received in the valving passage and sealing said passage, the valving member being mounted for reciprocal movement in the valving passage, a hollow needle (90) having a sharp point formed on a free end thereof received in the valving passage, means (92) supporting the needle in the valving passage for reciprocal movement in the valving passage, the valving body, valving member, support means and needle being so constructed, mounted and disposed that upon movement of the valving member in the valving passage in a predetermined direction the valving member moves the needle in the direction of the sharp point thereof, the valve body, needle and support means being composed of material which is chemically inert.

**Patentansprüche**

1. Behälter zum Versand, zur Lagerung und Verwendung von ultrasauberen, korrosiven und giftigen, flüssigen, zur Herstellung von Halbleitern verwendbaren Reagenzmitteln, die gegen Luft und Abgabe von Gas oder Dampf durch Behälterwände geschützt sein müssen, wobei er einen Kessel (10) mit Wänden aus einem gas- und dampfundurchlässigen Material einschliesst, das zum darin vorhandenen flüssigen Reagenzmittel chemisch inert ist, wobei der Kessel im Oberteil einen Einlass (12) hat, mit dem ein Rohr (14) zum Durchlassen eines Fluids zu einer unteren Zone im Inneren des Kessels verbunden ist, damit ein Gas unter der Oberfläche des flüssigen Reagenzmittels im Kessel behalten wird, wobei in der oberen Zone des Kessels ein Auslass (18) vorhanden ist, über den flüssiges, Dampf mitführendes Gas vom Kessel entfernt werden kann, und eine Dichtung am Einlass zur Bildung einer Barriere zum Durchlassen von Gas in den Kessel vorhanden ist, dadurch gekennzeichnet, dass die Dichtung folgendes aufweist:

I) eine erste Schicht (30) aus einem Material, das zum flüssigen Reagenzmittel zur Aufbewahrung im Kessel chemisch inert ist, wobei diese Schicht derart dick ist, dass sie von einer scharfen, hohlen Nadel durchstochen werden kann, und

II) eine zweite Schicht (32) aus nachgiebigem Material, die derart angeordnet ist, dass sie bei Verwendung leicht von einer scharfen Nadel durchstochen werden kann, und dabei diese Nadel in einer fluiddichten Dichtung fassen, wobei die erste Schicht gasundurchlässig ist und einen Gaseintritt in den Einlass durch die Dichtung verhindert, und dass Mittel (40) zur Sicherung der Dichtung am Einlass in einem fluidundurchlässigen Verhältnis zu ihr vorhanden sind.

2. Behälter nach Anspruch 1, dadurch gekennzeichnet, dass die Dichtung eine dritte Schicht (36) aus einem Material enthält, das zum flüssigen, zur Aufnahme in den Kessel vorgesehenen Reagenzmittel chemisch inert ist, wobei die dritte Schicht eine derartige Dicke aufweist, dass sie von einer scharfen, hohlen Nadel durchstochen werden kann.

3. Behälter nach Anspruch 2, dadurch gekennzeichnet, dass mindestens die erste (30) oder die dritte Schicht (36) aus einem Metall zusammengesetzt ist, das zu dem zur Aufnahme darin vorgesehenen, flüssigen Reagenzmittel inert und für ein Gas undurchlässig ist.

4. Behälter nach Anspruch 2 oder 3, dadurch gekennzeichnet, dass mindestens die erste oder die dritte Schicht aus Tetrafluoräthylen besteht.

5. Behälter nach einem der vorangehenden Ansprüche, dadurch gekennzeichnet, dass die zweite Schicht aus einem nachgiebigen synthetischen Gummipolymer besteht.

6. Behälter nach Anspruch 2, 3 oder 4, dadurch gekennzeichnet, dass die Dichtung ferner eine vierte Schicht (34) aus nachgiebigem Dichtungspolymer zwischen der zweiten und der dritten Schicht aufweist, wobei der Einlass vom Ende des Rohres (14) definiert ist, das sich in den Kessel hineinstreckt, und das Rohr eine ringförmige, im äusseren Umfang ausgeformte Rille (22) aufweist, und die Befestigungsmittel (40) einen ringförmigen Quetschbefestiger mit einem ersten, sich zwischen der zweiten und vierten Schicht der Dichtungsvorrichtung erstreckkenden Teil einschliesst, wobei ein Zwischenhülsenteil rund um einen Teil der Dichtung und einen Teil des Rohres angeordnet ist und sich ein Quetschteil in die ringförmige Rille in das Rohr erstreckt.

7. Behälter nach einem der vorangehenden Ansprüche, dadurch gekennzeichnet, dass ein Ventil (50) auf dem Rohr und in fluiddichter Verbindung mit diesem montiert ist, dass das Ventil einen Körper (52) mit einem durchgehenden Ventilkanal (56) einschliesst, der die Dichtung und einen weiteren Kanal (54) zur Herstellung einer Verbindung zwischen einem äusseren Rohr und dem Ventilkanal umfasst, dass ein Ventilkörper (80) für eine hin- und hergehende Bewegung im Ventilkanal zu dessen Abdichtung montiert ist, dass eine Hohlnadel (90) mit einer scharfen Spitze an ihrem freien Ende vorhanden ist, das im Ventilkanal aufgenommen und für eine hin- und hergehende Bewegung im Ventilkanal abgestützt ist, wobei der Ventilkörper, das Ventilglied und die Nadel aus einem Material bestehen, das zur in den Behälter aufzunemenden Flüssigkeit chemisch inert und derart angeordnet ist, dass das Ventilglied bei Bewegung desselben in einer vorbestimmten Richtung die scharfe Spitze der Nadel durch die Schichten der Dichtung drückt und dabei einen Pfad durch die Schichten vom Ventilkanal zum Kessel öffnet.

8. Behälter nach Anspruch 2, dadurch gekennzeichnet, dass mindestens die eine der ersten und dritten Schicht eine dünne inerte Metallplatte ist.

9. Verfahren zur Überführung eines äusserst sauberen korrosiven und giftigen flüssigen Reagenzmittels, das gegen den Einfluss von Gas oder Dampf durch die Wände zu oder von einem Kessel (10) nach einem der Ansprüche 1 bis 6 geschützt werden soll, dadurch gekennzeichnet, dass man:

a) ein Ventil (50) auf mindestens einem der Kesselrohre in einem Dichtungsverhältnis zu diesem montiert, wobei das Ventil einen Körper (52) mit einem durchgehenden Ventilkanal (56) zum Empfang des Rohres aufweist, wobei ein weiterer Kanal (54) für eine Verbindung zwischen einem äusseren Rohr und dem Ventilkanal benutzt wird, und eine Hohlnadel mit einer Spitze am freien Ende im Ventil vorhanden ist, das aus Material zusammengesetzt ist, das zum Reagenzmittel chemisch inert ist; und

b) die Nadel in einer vorbestimmten Richtung im Kanal und somit die scharfe Nadelspitze durch eine Dichtung im Rohr bewegt wird und dabei einen Fluidpfad durch die Dichtung vom Ventilkanal zum Kessel öffnet, damit das Reagenzmittel durch den Pfad aus oder zu dem Kessel bewegt werden kann.

10. Verfahren nach Anspruch 9, in einer Ausführung zur Herstellung von Halbleitern, wobei das Reagenzmittel vom Kessel transferiert wird, dadurch gekennzeichnet, dass man das Ventil auf der Einlassseite (12) des Kessels montiert, das Gas durch die Nadel und das Rohr in den Kessel unterhalb des Pegels des Reagenzmittels im Kessel einführt, und das dampftragende Gas vom Auslass des Kessels sammelt.

11. Ventil zur Verwendung mit dem Behälter nach einem der Ansprüche 1 bis 6, dadurch gekennzeichnet, dass ein Körper (52) mit einem durchgehenden Ventilkanal (56—60) als Verbindung zu einem Aussenrohr in Verbindung mit dem Ventilkanal vorhanden ist, dass ein Ventilglied (80—88) im Ventilkanal aufgenommen ist und diesen abdichtet, wobei das Ventilglied für eine hin- und hergehenden Bewegung im Ventilkalan ausgelegt ist, und eine Hohlnadel (90) mit einer Spitze am freien Ende in den Ventilkanal aufgenommen ist, und ferner eine Vorrichtung (92) zur Stützung der Nael im Ventilkanal für eine hin- und hergehenden Bewegung im Ventilkanal vorhanden ist, wobei der Ventilkörper, das Ventilglied, die Stützvorrichtung und die Nadel derart ausgebildet, montiert und angeordnet sind, dass bei einer Bewegung des Ventilgliedes im Ventilkanal in einer vorbestimmten Richtung, das Ventilglied die Nadel in der Richtung der Spitze bewegt, wobei der Ventilkörper, die Nadel und die Stützvorrichtung aus Material zusammengesetzt sind, das chemisch inert ist.

**Revendications**

1. Un conteneur pour le transport, le stockage et l'utilisation de réactifs liquides corrosifs et toxiques ultra-purs destinés à être utilisés dans la fabrication de semi-conducteurs, lesquels réactifs doivent être protégés d'une exposition à l'air et de l'émission de gaz ou de vapeur à travers les parois de confinement, le conteneur comprenant:

un récipient (10) comportant des parois de confinement constituées d'un matériau étanche au gaz et à la vapeur qui est chimiquement inerte au réactif liquide devant être contenu dans celui-ci, ledit récipient comprenant un orifice d'entrée (12) dans une région supérieure dudit récipient, un conduit (14) en communication de fluide avec ledit orifice d'entrée et s'étendant depuis celui-ci jusqu'à une région inférieure de l'intérieur du récipient servant à permettre au gaz d'être introduit en-dessous de la surface du réactif liquide devant être contenu dans le récipient, un orifice de sortie (18) dans la région supérieure du récipient par lequel un gaz portant une vapeur liquide peut être éliminé du récipient, et un joint disposé au niveau de l'orifice d'entrée pour constituer une barrière au passage du gaz dans le récipient, caractérisé en ce que le joint comprend:

(i) une première couche (30) d'un matériau qui est chimiquement inerte au réactif liquide devant être contenu dans ledit récipient, ladite première couche étant une couche d'une épaisseur telle qu'elle est apte à être pénétrée par une aiguille creuse pointue, et

(ii) une deuxième couche (32) d'un matériau élastique disposée de façon que lors de l'utilisation, elle soit facilement apte à être pénétrée par une aiguille creuse pointue et à serrer ladite aiguille dans un joint étanche au liquide avec celle-ci, la première couche étant étanche au gaz pour empêcher l'entrée de gaz dans l'orifice d'entrée à travers le joint, ceci constituant un moyen (40) fixant le joint au niveau de l'orifice d'entrée dans une relation d'étanchéité imperméable au liquide avec celui-ci.

2. Un conteneur comme revendiqué à la revendication 1, dans lequel le joint comprend une troisième couche (36) d'un matériau qui est chimiquement inerte au réactif liquide devant être contenu dans le récipient, la troisième couche étant une couche d'une épaisseur telle qu'elle est apte à être pénétrée par une aiguille creuse pointue.

3. Un conteneur selon la revendication 2, dans lequel au moins une de la première (30) et de la troisième (36) couches est constituée d'un métal qui est inerte au rectif liquide devant être contenu dans celui-ci et étanche au gaz.

4. Un conteneur selon la revendication 2 ou 3, dans lequel au moins une de la première et de la troisième couches est constituée de tétrafluoroéthylène.

5. Un conteneur selon l'une quelconque des revendications précédentes, dans lequel la deuxième couche est constituée d'un polymère de caoutchouc synthétique élastique.

6. Un conteneur selon la revendication 2, 3 ou 4, dans lequel:

le joint comprend en outre une quatrième couche (34) d'un polymère d'étanchéité élastique entre la deuxième et la troisième couches;

l'orifice d'entrée est défini par l'extrémité du conduit (14) qui s'étend dans le récipient;

le conduit comprend une rainure annulaire (22) formée dans le pourtour extérieur de celui-ci, et

le moyen de fixation (40) comprend une attache de serrage annulaire qui comprend une première partie s'étendant entre la deuxième et la quatrième couches du moyen de joint, une partie de manchon intermédiaire autour d'une partie du joint et une partie du conduit, et une partie du joint de serrage s'étendant dans la rainure annulaire dans le conduit.

7. Un conteneur tel que revendiqué dans l'une quelconque des revendications précédentes, comprenant une vanne (50) montée sur ledit conduit dans une relation étanche au fluide avec celui-ci, ladite vanne comprenant un corps (52) comprenant un passage d'échappement (56) à travers celui-ci qui renferme le joint et un passage (54) supplémentaire servant à assurer une communication entre un conduit externe et le passage d'échappement; un élément d'échappement (80) monté pour un déplacement en va-et-vient dans le passage d'échappement pour rendre étanche ledit passage d'échappement; une aiguille creuse (90) comportant une pointe aiguë formée sur une extrémité libre de celle-ci reçue dans le passage d'échappement et supportée pour un déplacement en va-et-vient dans le passage d'échappement; le corps d'échappement, l'élément d'échappement, et l'aiguille étant composés d'un matériau qui est chimiquement inerte au liquide devant être contenu dans le conteneur et disposé de telle sorte que lors du déplacement de l'élément d'échappement dans le passage d'échappement dans une direction prédéterminée, l'élément d'échappement force la point aiguë de l'aiguille à travers les couches du joint ouvrant de la sorte un trajet de fluide à travers les couches depuis le passage d'échappement vers le récipient.

8. Un conteneur selon la revendication 2, dans lequel au moins une de la première et de la troisième couches est une mince feuille de métal inerte.

9. Un procédé de transfert des réactifs liquides corrosifs et toxiques ultra-purs qui doivent être protégés de l'exposition à l'air et de l'émission de gaz ou de vapeur à travers les parois de confinement vers un récipient (10) ou depuis celui-ci, tel que revendiqué dans l'une quelconque des revendications 1 à 6, caractérisé par:

le montage d'une vanne (50) sur au moins un des conduits et orifice de sortie du récipient en relation étanche au liquide avec celle-ci, ladite vanne comprenant un corps (52) comprenant un passage d'échappement (56) à travers celui-ci qui reçoit le conduit, un passage supplémentaire (54), pour communication entre un conduit extérieur et le passage d'échappement, et une aiguille creuse comportant une pointe aiguë formée sur l'extrémité libre de celle-ci dans la vanne, la vanne étant constituée d'un matériau qui est chimiquement inerte au réactif, et

le déplacement de l'aiguille dans la vanne dans une direction prédéterminée forçant de la sorte la pointe aiguë de l'aiguille à travers un joint disposé dans le conduit, ouvrant de la sorte un trajet de liquide à travers le joint depuis le passage d'échappement jusqu'au récipient, permettant au réactif d'être retiré du récipient et introduit dans celui-ci via le trajet de liquide ainsi formé.

10. Un procédé tel que revendiqué dans la revendication 9, lorsque utilisé dans la fabrication de semi-conducteurs pour transférer un réactif dans le récipient, caractérisé par:

le montage de ladite vanne sur un orifice d'entrée (12) du récipient;

l'introduction d'un gaz à travers l'aiguille et le conduit dans le récipient en-dessous du niveau du réactif contenu dans le récipient, et

la récupération d'un gaz porteur de vapeur de réactif qui sort depuis un orifice de sortie du récipient.

11. Une vanne destinée à être utilisée avec le conteneur tel que revendiqué dans l'une quelconque des revendications 1 à 6, comportant un corps (52) comprenant un passage d'échappement (56 à 60) à travers celui-ci et un passage (54) pour communication vers un conduit extérieur en communication avec le passage d'échappement, un élément d'échappement (80 à 88) reçu dans le passage d'échappement et rendant étanche ledit passage, l'élément d'échappement étant monté pour un déplacement en va-et-vient dans le passage d'échappement, une aiguille creuse (90) comprenant une pointe aiguë formée sur une extrémité de celle-ci reçue dans le passage d'échappement, un moyen (92) supportant l'aiguille dans le passage d'échappement pour un déplacement en va-et-vient dans le passage d'échappement, le corps d'échappement, l'élément d'échappement, le moyen de support et l'aiguille étant réalisés, montés et disposés de telle sorte que lors du déplacement de l'élément d'échappement dans le passage d'échappement dans une direction prédéterminée, l'élément d'échappement déplace l'aiguille dans la direction de la pointe aiguë de celle-ci, le corps de vanne, l'aiguille et le moyen de support étant constitués d'un matériau qui est chimiquement inerte.

Fig. 1

Fig. 2

Fig. 3